Europäisches Patentamt

European Patent Office

Office européen des brevets

(19)

(11) Numéro de publication : **0 081 866**
**B1**

(12) **FASCICULE DE BREVET EUROPÉEN**

(45) Date de publication du fascicule du brevet :
04.03.87

(51) Int. Cl.⁴ : **B 29 D 7/01**, B 29 C 47/00

(21) Numéro de dépôt : 82201402.3

(22) Date de dépôt : 08.11.82

(54) Procédé et appareillage d'extrusion de films en polymères du fluorure de vinylidène.

(30) Priorité : 16.11.81 FR 8121538

(43) Date de publication de la demande :
22.06.83 Bulletin 83/25

(45) Mention de la délivrance du brevet :
04.03.87 Bulletin 87/10

(84) Etats contractants désignés :
AT BE CH DE FR GB IT LI LU NL SE

(56) Documents cités :
WO-A-81 /015 67
FR-A- 2 146 856
GB-A- 1 173 688
US-A- 2 728 951
US-A- 3 087 198
US-A- 3 402 428

(73) Titulaire : SOLVAY & Cie (Société Anonyme)
Rue du Prince Albert, 33
B-1050 Bruxelles (BE)

(72) Inventeur : Georlette, Pierre
Ardouf, 9
IL-Oner Alyad Beersheva· (IL)
Inventeur : Maquet, Nestor
Route de Hollogne
B-5406 Waha (BE)

Jouve, 18, rue St-Denis, 75001 Paris, France

## Description

La présente invention concerne un procédé pour l'extrusion de films en polymère du fluorure de vinylidène, un procédé pour la fabrication de films piézoélectriques à partir de films obtenus selon le procédé précité ainsi qu'un appareillage pour la réalisation du procédé précité.

On sait actuellement produire des films en polymères du fluorure de vinylidène qui sont doués de propriétés piézoélectriques remarquables et qui conviennent particulièrement bien pour l'industrie électronique.

Ainsi, dans le brevet GB-A-1 339 295 (KUREHA KAGAKU KOGYO K.K.), on décrit une technique conduisant à des films de polyfluorure de vinylidène doués de propriétés piézoélectriques élevées qui consiste à soumettre à une tension continue de polarisation comprise entre 200 et 1 500 KV/cm un film de ce polymère constitué de manière prépondérante de cristaux de type bêta. Selon ce document, il n'est pas possible de produire directement le film de départ par extrusion et refroidissement car cette technique conduit toujours à des films contenant essentiellement des cristaux de type alpha qui, de ce fait, ne conviennent pas. Pour obtenir un film de départ convenable, il faut, selon ce document, soumettre un film extrudé et refroidi à une opération supplémentaire d'étirage mono- ou biaxial à une température inférieure à 130 °C et, de préférence, inférieure à 50 °C de façon à convertir les cristaux de type alpha en cristaux du type bêta. Ce traitement d'étirage doit être conduit avec soin et à faible vitesse afin d'assurer la conversion cristallographique souhaitée. Afin d'alléger le processus de fabrication, on se contente généralement de soumettre le film de cristallinité alpha à un étirage longitudinal. Il apparaît toutefois que cet étirage monoaxial réalisé à basse température conduit à un affaiblissement des propriétés mécaniques transversales du film, ce dernier pouvant même avoir tendance à fibriller. En outre, le film présente une résistance à la déchirure après entaille qui est déficiente. On obtient donc ainsi des films dont les propriétés mécaniques ne sont pas satisfaisantes.

Dans le brevet GB-A-1 173 688 (KUREHA KAGAKU KOGYO K.K.) on décrit également un procédé pour produire un film de polyfluorure de vinylidène ayant des propriétés mécaniques selon lequel le film est soumis à un étirage dans au moins une direction à température ambiante ou à température plus élevée. En fait dans ce procédé selon les exemples illustratifs, le film extrudé est refroidi rapidement puis réchauffé à 150 °C.

La présente invention vise à procurer un procédé qui permet la production directe par extrusion et refroidissement de films de polymères du fluorure de vinylidène présentant une structure cristalline prépondérante de type bêta et qui, de ce fait, conviennent bien pour la fabrication de films piézoélectriques et ne présentent pas les défauts des films obtenus selon les procédés connus. L'invention concerne un procédé pour l'extrusion de films en polymère du fluorure de vinylidène, dans lequel on soumet un film extrudé de polymère fondu à un étirage dans la direction de l'extrusion d'au moins 200 % et on refroidit le film étiré caractérisé en ce que :

— le traitement d'étirage s'effectue à la sortie de la filière sans aucun traitement intermédiaire ; le film se trouvant encore dans son état fondu ;

— le refroidissement est un refroidissement rapide où l'on refroidit le film étiré à une température inférieure à 50 °C ;

— ce refroidissement s'effectue en même temps que le traitement d'étirage après un parcours au sortir de la filière de 300 mm au plus.

Par polymères du fluorure de vinylidène, on entend désigner tous les polymères contenant au moins 50 % molaires et, de préférence, au moins 85 % molaires d'unités monomériques dérivées du fluorure de vinylidène. Les polymères du fluorure de vinylidène qui conviennent à la réalisation du procédé selon l'invention comprennent donc aussi bien les homopolymères du fluorure de vinylidène que ses copolymères contenant des unités monomériques dérivées d'un ou de plusieurs comonomères. Des résultats particulièrement avantageux sont obtenus avec les polymères du fluorure de vinylidène contenant au moins 85 % molaires et, de préférence, 100 % molaires d'unités monomériques dérivées du fluorure de vinylidène, le complément éventuel étant constitué de préférence d'unités monomériques dérivées d'autres oléfines fluorées, tels que le fluorure de vinyle, le trifluoréthylène, le chlorotrifluoréthylène, le tétrafluoréthylène et l'hexafluorpropylène.

Dans le procédé selon l'invention, le film extrudé, qui peut se présenter sous la forme d'un film plan ou d'une gaine tubulaire, est soumis à un étirage dans la direction de l'extrusion alors que le polymère se trouve encore à l'état fondu.

L'invention concerne aussi un appareillage pour la réalisation du procédé décrit ci-dessus, comprenant en série un dispositif d'extrusion, équipé d'une filière verticale pour la production d'un film, un dispositif d'étirage et un dispositif de refroidissement caractérisé en ce que :

— le dispositif d'étirage, composé d'au moins un cylindre, est contenu dans ou constitué par le dispositif de refroidissement ;

— le dispositif de refroidissement est un dispositif de refroidissement rapide pouvant être un bain liquide ou pouvant être formé d'au moins d'un cylindre de réfrigération, ce dispositif étant situé à une distance de la filière inférieure à 300 mm.

L'extrusion du film et l'étirage consécutif du film fondu s'effectuent à une température comprise entre la température de fusion et la température de dégradation thermique du polymère constitutif. La température optimale d'extrusion dépend bien entendu des caractéristiques rhéologiques du polymère. Elle se situe, en général, entre sa température de fusion et 325 °C environ. Le film est donc étiré à une température au moins égale à la température de fusion de son polymère constitutif, lequel se trouve par conséquent à l'état amorphe lors de l'étirage. Le taux d'étirage est d'au moins 200 % et de préférence d'au moins 500 % mais il peut atteindre et même dépasser des valeurs de 5 000 %. Comme cet étirage est exercé sur le polymère fondu et amorphe, il est sans incidence sur les propriétés mécaniques tant dans la direction d'extrusion que dans la direction transversale au film produit. Etant donné que l'étirage imposé au film extrudé conduit à une diminution importante de son épaisseur, il est avantageux, afin d'éviter un refroidissement néfaste du film au cours de l'étirage d'effectuer ce dernier à grande vitesse. Ainsi, on préfère réaliser cet étirage à une vitesse du film après étirage au moins égale à 10 m/min et, de préférence, au moins égale à 50 m/min.

Après avoir été étiré en fondu, le film est refroidi rapidement à une température inférieure à 50 °C, de préférence, inférieure à 35 °C et plus particulièrement inférieure à 20 °C. Il importe toutefois d'assurer un refroidissement rapide du film.

Selon un mode de réalisation de l'invention, la réfrigération du film étiré en fondu est obtenue en mettant le film extrudé et étiré en contact direct avec un cylindre refroidi. Dans ce cas, il est souhaitable que le cylindre soit maintenu à une température inférieure à 20 °C, de préférence, inférieure à 15 °C et plus particulièrement inférieure à 10 °C.

Selon l'autre mode de réalisation de l'invention particulièrement efficace, auquel on donne par conséquent la préférence, la réfrigération du film étiré en fondu est obtenue par trempage dans un bain liquide thermostatisé à une température inférieure à 50 °C et, de préférence, inférieure à 25 °C, le liquide pouvant être de l'eau ou encore un mélange d'eau et d'éthylèneglycol.

Dans le procédé selon l'invention, le film est refroidi le plus rapidement possible après son étirage et, dès lors, la zone de refroidissement est avantageusement située à proximité de la filière d'extrusion. Ainsi, il s'est révélé particulièrement intéressant de refroidir le film étiré après un parcours, au sortir de la filière, de 300 mm, et de préférence de 100 mm, au plus. En général, pour des raisons pratiques, ce parcours est supérieur à 10 mm.

Après refroidissement, le film peut être bobiné, après avoir été séché le cas échéant. Le film peut également être soumis ultérieurement à un traitement de recuit effectué généralement à des températures comprises entre 75 °C et le point de fusion de son polymère constitutif. Le film peut, en outre, être métallisé par les procédés habituels, et ce sur une de ses faces ou sur les deux.

En vue de conférer des propriétés piézoélectriques ou pyroélectriques au film obtenu selon le procédé décrit ci-avant, on le soumet à un traitement de polarisation qui peut être effectué selon tout procédé connu en soi et, par exemple, par effet corona ou en appliquant un champ électrique constant ou variable, le film se trouvant à une température inférieure au point de fusion du polymère.

Pour réaliser le procédé selon l'invention, on utilise un appareillage qui comporte en série un dispositif d'extrusion équipé d'une filière verticale pour la production d'un film, un dispositif d'étirage et un dispositif de refroidissement situé à une distance de la filière inférieure à 300 mm. Cet appareillage peut être suivi par un dispositif de bobinage et éventuellement par un dispositif de recuit.

Selon un mode de réalisation particulièrement préféré, le dispositif de réfrigération est constitué par un bain liquide et le dispositif d'étirage est constitué par deux cylindres presseurs adjacents immergés dans le bain liquide et entraînés en rotation en sens contraire par exemple par un moteur à vitesse variable. En général, le bain est thermostatisé.

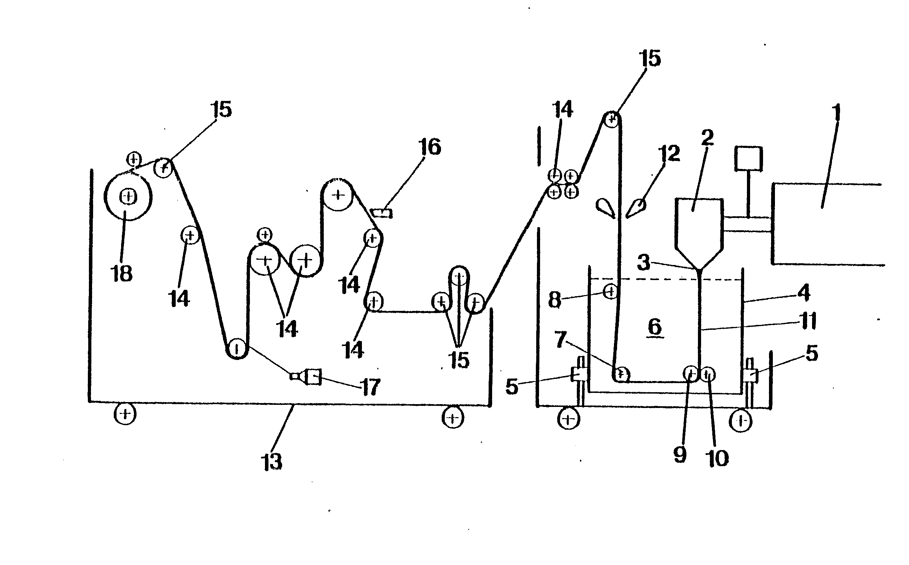

Un appareillage de ce type est illustré schématiquement dans la figure unique du dessin annexé.

Ainsi qu'il apparaît sur cette figure, l'appareillage comprend une extrudeuse 1 équipée d'une filière plate verticale classique 2 dont les lèvres sont écartées d'une distance pouvant varier entre 0,3 et 1 millimètre. L'appareillage comporte, en outre, une cuve 4 montée sur des vérins de réglage 5, cette cuve étant située au droit de la filière, thermostatisée et remplie d'un liquide de refroidissement 6, par exemple de l'eau. Les vérins de réglage sont adaptés de façon telle que la distance séparant l'extrémité de la filière 2 du niveau du bain 6 de refroidissement puisse varier entre 20 et 300 mm. En outre, la cuve comporte des rouleaux de renvoi et de guidage 7, 8 et des rouleaux presseurs 9, 10 immergés et entraînés par un moteur à vitesse variable, non représenté et adapté de façon à pouvoir exercer sur le film extrudé 11 un effort de traction. Un dispositif 12 de séchage du film est prévu à la sortie de la cuve 4. L'appareillage comporte, en outre, un bobinoir 13 équipé de rouleaux de renvoi 14, de rouleaux déplisseurs 15, d'un système 16, 17 de découpe et d'évacuation des lisières et d'un rouleau bobinoir 18.

Les vitesses des rouleaux 14, 15 et 18 sont réglées de façon telle que la portion de film située entre la sortie de la cuve 4 et le bobinoir 18 soit tendue mais non soumise à un effort de traction sensible.

Selon l'autre mode de réalisation, non illustré, le dispositif de réfrigération et d'étirage est constitué par au moins un cylindre de refroidissement qui est maintenu à une température inférieure à 20 °C et, de préférence, à 15 °C. Le premier cylindre est disposé de façon telle que le contact initial entre le film extrudé et ce cylindre soit situé à une distance de la filière inférieure à 300 mm. Le ou les cylindres de réfrigération sont de préférence des cylindres métalliques éventuellement revêtus d'une mince pellicule antiadhérente. En outre, la vitesse de rotation des cylindres est réglée de façon telle que le film extrudé soit étiré d'au moins 200 % dans la direction d'extrusion et ce entre la filière et le premier cylindre de réfrigération.

Dans le brevet US-A-3 402 428 (AVISUM CORP), on a divulgué un appareillage pour la production d'un film plastique continu comprenant un dispositif d'extrusion et un dispositif de refroidissement constitué par un bain liquide, le film refroidi étant ultérieurement soumis à un étirage biaxial (col. 5, lignes 23 à 25).

Les exemples 1 à 5 dont la relation suit ont été réalisés avec un appareillage selon le premier mode particulier de réalisation décrit ci-avant dans lequel l'extrudeuse était une extrudeuse TROESTER UP60 équipée d'une filière plate REIFENHAUSER de 400 mm de largeur et le bobinoir un bobinoir SPANN-KRAFT.

## Exemple 1

Dans l'extrudeuse 1, on introduit du polyfluorure de vinylidène homopolymère de marque SOLEF et de type 1008 produit et commercialisé par SOLVAY & Cie.

On règle les différents paramètres d'extrusion de façon à produire au niveau de la filière un film de 0,5 mm d'épaisseur se trouvant à une température de 250 °C. A l'aide des vérins 5, on règle la hauteur d'un bain liquide thermostatisé constitué par de l'eau à 30 °C de façon que le niveau du bain soit situé à une distance de 20 mm de l'extrémité de la filière 2. Le film extrudé est introduit entre les rouleaux presseurs 9, 10 dont l'écartement et la vitesse sont réglés de façon telle que ceux-ci exercent un effort de traction sur le film et l'entraînent à une vitesse de 11 m/min de façon à étirer le film dans sa portion située entre la filière et le niveau du bain et à réduire son épaisseur à 0,04 mm. Enfin, on amène le film extrudé sur le bobinoir 18.

Lorsque l'installation fonctionne en régime, on prélève des échantillons de film au niveau du bobinoir 18 et on détermine leurs propriétés de résistance mécanique dans le sens longitudinal et dans le sens transversal ainsi que le rapport d'absorption $D_{530}/D_{510}$ par spectrographie d'absorption en infra-rouge. On considère qu'un film de polyfluorure de vinylidène possède suffisamment de cristaux de type bêta et convient particulièrement pour des applications piézoélectriques lorsque le rapport $D_{530}/D_{510}$ est inférieur à 1,2 et de préférence inférieur à 1 (brevet GB-A-1 339 295 précité). Les valeurs relevées sont reprises dans le Tableau I ci-après.

## Exemple 2

On opère exactement comme à l'exemple 1 mis à part les modifications suivantes :
— épaisseur initiale du film extrudé : 0,35 mm
— distance entre la filière et le niveau du bain : 70 mm
— température du bain : 20 °C
— vitesse de traction : 23 m/min.

On obtient un film de 0,02 mm d'épaisseur sur lequel on prélève des échantillons qui sont soumis aux mêmes déterminations qu'à l'exemple 1. Les résultats enregistrés sont repris au Tableau I ci-après.

## Exemple 3

On opère exactement comme à l'exemple 2 mis à part que la vitesse de traction est portée à 30 m/min.

On obtient un film de 0,015 mm d'épaisseur sur lequel on prélève des échantillons qui sont soumis aux mêmes déterminations qu'à l'exemple 1. Les résultats enregistrés sont repris au Tableau I ci-après.

## Exemple 4

On opère exactement comme à l'exemple 2 mis à part que la vitesse de traction est portée à 35 m/min.

On obtient un film de 0,01 mm d'épaisseur sur lequel on prélève des échantillons qui sont soumis aux mêmes déterminations qu'à l'exemple 1. Les résultats enregistrés sont repris au Tableau I ci-après.

(Voir Tableau I p. 5)

**0 081 866**

Tableau I

| Exemple | Epaisseur, . mm | Résistance transversale à la traction MPa | Résistance longitudinale à la traction MPa | $D_{530}/D_{510}$ |
|---------|-----------------|-------------------------------------------|--------------------------------------------|-------------------|
| 1 | 0,040 | 43 | 49 | 0,90 |
| 2 | 0,020 | 45 | 52 | 0,68 |
| 3 | 0,015 | 35 | 39 | 0,57 |
| 4 | 0,010 | 37 | 38 | 0,27 |

Les résultats enregistrés font apparaître que les films obtenus conviennent parfaitement pour fabriquer des films piézoélectriques. Ces films ne présentent pas d'affaiblissement important de leur résistance mécanique dans le sens transversal. En outre, ils présentent une excellente résistance à la déchirure après entaille.

Exemple 5

Dans l'appareillage décrit ci-avant, on utilise une filière ronde d'un diamètre de 8 mm équipée d'un noyau de diamètre de 5 mm.

Le bain thermostatisé est maintenu à 18 °C et son niveau est maintenu à une distance de 120 mm de l'extrémité de la filière d'extrusion.

Dans l'extrudeuse on introduit du polyfluorure de vinylidène homopolymère de marque SOLEF et de type 1010 produit et commercialisé par SOLVAY & Cie et on règle les paramètres d'extrusion de façon à extruder un tube à une température de 215 °C. Ce tube est introduit entre les rouleaux presseurs dont l'écartement et la vitesse sont réglés de façon telle que ceux-ci exercent un effort de traction sur le tube et l'entraînent à une vitesse de 20 m/min.

Lorsque l'installation fonctionne en régime, on obtient une gaine tubulaire ayant une épaisseur de paroi de 0,3 mm qui convient parfaitement pour le gainage de fibres optiques.

Exemple 6

Dans une extrudeuse équipée d'une filière plate, on introduit du polyfluorure de vinylidène homopolymère de marque SOLEF et de type 1008 produit et commercialisé par SOLVAY & Cie et on règle les paramètres d'extrusion de façon à produire au niveau de la filière, un film de 0,5 mm d'épaisseur se trouvant à 250 °C.

A une distance de la filière de 70 mm, le film extrudé est appliqué contre un cylindre de refroidissement qui est maintenu à une température de 7,5 °C par circulation d'un fluide réfrigérant. La vitesse de rotation du cylindre de refroidissement est réglée de façon telle que le film extrudé soit étiré à l'état fondu et dans la direction d'extrusion dans une mesure telle que son épaisseur soit réduite à 0,040 mm. Le film refroidi et étiré est ensuite amené sur un bobinoir par l'intermédiaire d'une série de cylindres déplisseurs et ce, sans exercer une traction substantielle sur ce film.

Lorsque l'installation fonctionne en régime, on prélève des échantillons du film produit au niveau du bobinoir et, sur ceux-ci, on détermine le rapport d'absorption $D_{530}/D_{510}$ par spectrographie d'absorption en infra-rouge. On constate que ceux-ci présentent un rapport $D_{530}/D_{510}$ de 0,69, ce qui implique qu'ils sont de structure cristalline prépondérante de type bêta et conviennent particulièrement pour fabriquer des films piézoélectriques.

On détermine également la résistance à la traction de ces échantillons tant dans le sens transversal que dans le sens longitudinal et on constate que ces résistances s'élèvent respectivement à 45 et 50 MPa. Ces derniers résultats montrent, d'une part, que le film obtenu a des propriétés mécaniques voisines dans les deux sens et, d'autre part, que le film n'a pas subi un étirage sensible après son refroidissement.

Exemple 7 (de comparaison)

On procède comme à l'exemple 6, mis à part que le cylindre de refroidissement est maintenu à 30 °C, ce qui ne permet pas un refroidissement suffisamment rapide du film étiré en fondu.

5

Le rapport $D_{530}/D_{510}$ mesuré sur des échantillons du film ainsi obtenu au niveau du bobinoir s'élève à 9, ce qui indique que la structure cristalline prépondérante du film ainsi obtenu est du type alpha et que ce film ne convient donc guère pour fabriquer des films piézoélectriques.

Un échantillon de film prélevé sur le bobinoir est ensuite, selon l'art antérieur, soumis à un étirage de 500 % dans le sens de son extrusion ce qui a pour premier effet de réduire son épaisseur à 0,010 mm.

Le rapport $D_{530}/D_{510}$ mesuré sur le film ainsi obtenu s'élève à 0,1 ce qui implique que sa structure cristalline prépondérante est devenue du type bêta.

On détermine également la résistance en traction de l'échantillon ainsi obtenu, tant dans le sens transversal que dans le sens longitudinal, et on constate que ces résistances s'élèvent respectivement à 5 et 370 MPa. Il apparaît donc que les résistances mécaniques sont fortement différentes et que le film obtenu est peu résistant dans le sens perpendiculaire à la direction d'étirage.

**Revendications**

1. Procédé pour l'extrusion de films en polymère du fluorure de vinylidène, dans lequel on soumet un film extrudé de polymère fondu à un étirage dans la direction de l'extrusion d'au moins 200 % et on refroidit le film étiré caractérisé en ce que :
— le traitement d'étirage s'effectue à la sortie de la filière sans aucun traitement intermédiaire ; le film se trouvant encore à l'état fondu ;
— le refroidissement est un refroidissement rapide où l'on refroidit le film étiré à une température inférieure à 50 °C ;
— ce refroidissement s'effectue en même temps que le traitement d'étirage après un parcours au sortir de la filière de 300 mm au plus.

2. Procédé selon la revendication 1, caractérisé en ce que l'on soumet le film à un étirage d'au moins 500 % et qu'on le refroidit rapidement à une température inférieure à 35 °C.

3. Procédé selon la revendication 1 ou 2, caractérisé en ce qu'on refroidit le film étiré après un parcours au sortir de la filière de 100 mm au plus.

4. Procédé selon l'une quelconque des revendications 1 à 3, caractérisé en ce que l'étirage est réalisé à une vitesse de film après étirage au moins égale à 50 m/min.

5. Procédé pour la fabrication de films piézoélectriques à partir de films obtenus selon le procédé de l'une quelconque des revendications 1 à 4, caractérisé en ce qu'on soumet ce film à un traitement de polarisation.

6. Procédé selon l'une quelconque des revendications 1 à 5, caractérisé en ce qu'il est appliqué à du polyfluorure de vinylidène homopolymère.

7. Procédé selon l'une quelconque des revendications 1 à 5, caractérisé en ce qu'il est appliqué à un copolymère du fluorure de vinylidène contenant au moins 85 % molaires de fluorure de vinylidène.

8. Appareillage pour la réalisation du procédé selon l'une quelconque des revendications 1 à 5, comprenant en série un dispositif d'extrusion (1), équipé d'une filière verticale (2) pour la production d'un film (11), un dispositif d'étirage (9, 10) et un dispositif de refroidissement (6) caractérisé en ce que :
— le dispositif d'étirage, composé d'au moins un cylindre (9, 10), est contenu dans ou est constitué par le dispositif de refroidissement (6) ;
— le dispositif de refroidissement (6) est un dispositif de refroidissement rapide pouvant être un bain liquide (6) ou pouvant être formé d'au moins un cylindre de réfrigération, ce dispositif étant situé à une distance de la filière inférieure à 300 mm.

9. Appareillage selon la revendication 8, caractérisé en ce que le dispositif d'étirage est constitué par deux cylindres presseurs (9, 10) entraînés en rotation en sens contraire.

**Claims**

1. Process for the extrusion of vinylidene fluoride polymer films, in which an extruded film of the molten polymer is subjected to stretching in the direction of the extrusion by at least 200 % and the stretched film is cooled, characterized in that :
— the stretching treatment is carried out on exit from the die without any intermediate treatment, the film still being in the molten state ;
— the cooling is a rapid cooling, in which the stretched film is cooled to a temperature less than 50 °C ;
— the cooling is carried out at the same time as the stretching treatment after travelling through not more than 300 mm on leaving the die.

2. Process according to claim 1, characterized in that the film is subjected to stretching of at least 500 % and in that it is rapidly cooled to a temperature less than 35 °C.

3. Process according to claim 1 or 2, characterized in that the stretched film is cooled after travelling to through not more than 100 mm on leaving the die.

4. Process according to any one of claims 1 to 3, characterized in that stretching is carried out at a film speed after stretching of at least 50 m/min.

5. Process for the manufacture of piezoelectric films from films obtained according to the process of any one of claims 1 to 4, characterized in that this film is subjected to a polarization treatment.

6. Process according to any one of claims 1 to 5, characterized in that it is applied to polyvinylidene fluoride homopolymer.

7. Process according to any one of claims 1 to 5, characterized in that it is applied to a vinylidene fluoride copolymer containing at least 85 % (in mols) of vinylidene fluoride.

8. Apparatus for the implementation of the process according to any one of claims 1 to 5, comprising, in series, an extrusion device (1), equiped with a vertical die (2) for the production of a film (11), a stretching device (9, 10), and a cooling device (6), characterized in that :

— the stretching device, consisting of at least one roller (9, 10), is contained in or consists of the cooling device (6) ;

— the cooling device (6) is a rapid cooling device which may be a liquid bath (6), or which may be formed by at least one cooling roller, this device being positioned at a distance less than 300 mm from the die.

9. Apparatus according to claim 8, characterized in that the stretching device consists of two press rollers (9, 10) driven in rotation in the opposite direction.


**Patentansprüche**

1. Verfahren zur Extrusion von Folien aus Vinylidenfluorid-Polymeren, worin man eine extrudierte Folie aus geschmolzenem Polymer einem Recken in der Extrusionsrichtung von mindestens 200 % aussetzt und die gereckte Folie abkühlt, dadurch gekennzeichnet, daß :

— die Behandlung des Reckens an dem Ausgang der Düse ohne irgendeine dazwischenliegende Behandlung bewirkt wird, wobei sich die Folie noch in geschmolzenem Zustand befindet,

— die Abkühlung eine schnelle Abkühlung ist, wobei man die gereckte Folie auf eine Temperatur unterhalb von 50 °C abkühlt,

— diese Abkühlung zur selben Zeit wie die Behandlung des Reckens nach einer Strecke ab dem Verlassen der Düse von höchstens 300 mm bewirkt wird.

2. Verfahren nach Anspruch 1, dadurch gekennzeichnet, daß man die Folie einem Recken von mindestens 500 % aussetzt, und daß man sie schnell auf eine Temperatur unterhalb von 35 °C abkühlt.

3. Verfahren nach Anspruch 1 oder 2, dadurch gekennzeichnet, daß man die gereckte Folie nach einer Strecke ab Verlassen der Düse von höchstens 100 mm abkühlt.

4. Verfahren nach einem der Ansprüche 1 bis 3, dadurch gekennzeichnet, daß das Recken bei einer Geschwindigkeit der Folie nach dem Recken von mindestens gleich 50 m/min verwirklicht wird.

5. Verfahren zur Herstellung von piezoelektrischen Folien aus Folien, die nach dem Verfahren nach einem der Ansprüche 1 bis 4 erhalten werden, dadurch gekennzeichnet, daß man diese Folie einer Polarisationsbehandlung aussetzt.

6. Verfahren nach einem der Ansprüche 1 bis 5, dadurch gekennzeichnet, daß es auf Polyvinylidenfluorid-Homopolymer angewandt wird.

7. Verfahren nach einem der Ansprüche 1 bis 5, dadurch gekennzeichnet, daß es auf ein Vinylidenfluorid-Copolymer, das mindestens 85 Mol% Vinylidenfluorid enthält, angewandt wird.

8. Apparatur zur Verwirklichung des Verfahrens nach einem der Ansprüche 1 bis 5, enthaltend in Serie eine Extrusionsvorrichtung (1), ausgestattet mit einer vertikalen Düse (2) zur Herstellung einer Folie (11), eine Vorrichtung zum Recken (9, 10) und eine Vorrichtung zur Kühlung (6), dadurch gekennzeichnet, daß :

— die Vorrichtung zum Recken, die aus mindestens einer Walze (9, 10) gebildet ist, enthalten ist in oder gebildet wird durch die Vorrichtung zum Kühlen (6),

— die Vorrichtung zum Kühlen (6) eine Vorrichtung zum schnellen Kühlen ist, die ein flüssiges Bad (6) sein kann oder durch mindestens eine Kühlwalze gebildet werden kann, wobei diese Vorrichtung in einem Abstand zu der Düse von weniger als 300 mm befindlich ist.

9. Apparatur nach Anspruch 8, dadurch gekennzeichnet, daß die Vorrichtung zum Recken durch zwei Druckwalzen (9, 10) gebildet ist, die in gegenläufiger Rotation angetrieben sind.